# EUROPEAN PATENT APPLICATION

(11) **EP 2 498 061 A2**
(43) Date of publication of application: **12.09.2012**
(21) Application number: 12157870.2
(22) Date of filing: 02.03.2012
(51) Int. Cl.: G01D 4/00, G01R 31/28

(54) **Monitoring system for an electrical device**

(30) Priority: 09.03.2011 US 201113043810
(71) Applicant: General Electric Company, Schenectady, NY 12345 (US)
(72) Inventor: Sharma, Sandeep Vedviash, 500081 Andhra Pradesh (IN); Rameshchandra, Supeda Prahladbhai, 500081 Andhra Pradesh (IN); Vadali, Manoj Kumar, 560066 Bangalore, Karnataka (IN)
(74) Representative: Cleary, Fidelma

(57) **Abstract**

Systems and solutions for monitoring an electrical device (120, 232, 234) are disclosed. In one embodiment, a monitoring system (100, 200) for an electrical device (120, 232, 234) includes: a utility meter (110) communicatively connected to the electrical device (120, 232, 234); and at least one computing device (124) disposed within the utility meter (110), the at least one computing device (124) adapted to monitor the electrical device (120, 232, 234) by performing actions comprising: obtaining operational data (430) about the electrical device (120, 232, 234); (P2A) comparing the operational data (430) about the electrical device (120, 232, 234) with predefined operational criteria (434) for the electrical device (120, 232, 234); (P3) determining a health status for the electrical device (120, 232, 234) based upon the comparison of the operational data (430) about the electrical device (120, 232, 234) and the predefined operational criteria (434) for the electrical device (120, 232, 234); (D2) and providing to the utility meter (110) a health status indicator, the health status indicator including an operational status of the electrical device (120, 232, 234). (P4).

## Description

### BACKGROUND OF THE INVENTION

The subject matter disclosed herein relates generally to meter technology, and more particularly, to tools for monitoring electrical devices communicatively connected to a utility meter.

Some electrical devices, for example, certain air conditioners, washing machines or refrigerators, have fault display systems included in their design. These fault display systems may include a digital display, a warning light and/or an audible alarm communicatively connected to at least one sensor. In response to an electrical short or other similar undesirable operating condition detected by the at least one sensor, the system is designed to notify a consumer so that preventative or corrective action can be taken. However, these error messages do not provide specific operational data, instead merely indicating that an error exists and providing little to no diagnostic assistance. Additionally, electrical devices which have begun to fail or degrade but have not gotten to the point where they have triggered an error message, may remain in operation unbeknownst to consumers or the utility, operating inefficiently, avoiding preventative maintenance and concealing a potentially dangerous condition.

### BRIEF DESCRIPTION OF THE INVENTION

Systems for monitoring electrical devices communicatively connected to metered services are disclosed. In one embodiment, a monitoring system for an electrical device includes: a utility meter communicatively connected to the electrical device; and at least one computing device disposed within the utility meter, the at least one computing device adapted to monitor the electrical device by performing actions comprising: obtaining operational data about the electrical device; comparing the operational data about the electrical device with predefined operational criteria for the electrical device; determining a health status for the electrical device based upon the comparison of the operational data about the electrical device and the predefined operational criteria for the electrical device; and providing to the utility meter a health status indicator, the health status indicator including an operational status of the electrical device.

In a first aspect the invention provides a method of monitoring an electrical device, the electrical device communicatively connected to a utility meter, the method comprising: obtaining operational data about the electrical device; comparing the operational data about the electrical device with predefined operational criteria for the electrical device; determining a health status for the electrical device based upon the comparison of the operational data about the electrical device and the predefined operational criteria for the electrical device; and providing to the utility meter a health status indicator, the health status indicator including an operational status of the electrical device.

A second aspect provides a computer program arranged to perform the above method when run a computer and in the computer program stored on a computer readable medium

In a third aspect, the invention resides in a monitoring system for an electrical device comprising: a utility meter communicatively connected to the electrical device; and at least one computing device disposed within the utility meter, the at least one computing device adapted to monitor the electrical device by performing the steps of the above method.

A forth aspect of the invention provides a utility meter including: a meter base configured to be connected to a power source and communicatively connectable to at least one electrical device; and a computing device communicatively connected to the meter base, the computing device adapted to determine a health status of the at least one electrical device by performing the steps of the method described above.

### BRIEF DESCRIPTION OF THE DRAWINGS

Embodiments of the present invention will now be described, by way of example only, with reference to the accompanying drawings in which:
Fig. 1 shows a schematic illustration of an environment including a monitoring system for an electrical device in accordance with an embodiment of the invention.
Fig. 2 shows a schematic illustration of an environment including a monitoring system for an electrical device in accordance with an embodiment of the invention.
Fig. 3 shows a method flow diagram illustrating a process according to embodiments of the invention.
Fig. 4 shows a schematic illustration of an environment including a monitoring system for an electrical device in accordance with an embodiment of the invention.

It is noted that the drawings of the disclosure are not necessarily to scale. The drawings are intended to depict only typical aspects of the disclosure, and therefore should not be considered as limiting the scope of the disclosure. In the drawings, like numbering represents like elements between the drawings.

### DETAILED DESCRIPTION OF THE INVENTION

As indicated above, aspects of the invention provide for systems and solutions configured to monitor the operational characteristics and performance of electrical devices communicatively connected to a utility meter. The utility meter is configured to obtain operational data (e.g. electrical parameters or a combination of electrical parameters such as a voltage magnitude, a current magnitude, a power factor, a fault message, a error message, an amount of power consumption etc.) from at least one electrical device and to process the operational data using a Device Health Monitoring System (DHMS) including a health prediction algorithm to determine a health status of the at least one electrical device. The health status being a health of the device, an indication and/or determination as to the operating conditions, degradation, faults, errors and efficiency of the electrical device. The DHMS compares the operational data to predefmed operational criteria for the electrical device, the predefined operational criteria being based upon original operational design values specific to the at least one electrical device and being stored on at least one of the utility meter, the electrical device and a utility network. From this comparison, the DHMS determines a health status of the at least one electrical device based upon operating conditions and the variance between the operational data and the predefined operational criteria, and provides a health status indicator to the utility meter. The operational data is stored on the utility meter thereby generating/creating an operational health profile for the at least one electrical device which is available for periodic or prompted transmission to the utility or consumer. This provides a secure localized system which is capable of obtaining operational data, developing operational profiles, and reporting the health status of a plurality of electrical devices. As a result, the utility company and the consumer are able to securely monitor the performance of electrical devices connected to the utility meter, thereby avoiding potentially hazardous situations, performing preventative maintenance and optimizing performance and consumption of services.

Sensors in electrical devices are often connected to alarms or displays such as a buzzer, audible alarm or flashing light, these alarms for alerting consumers as to an unsafe operating condition in the electrical device. However, these alarms and alerts do not provide a localized comprehensive data set or profile of the operational condition of a given electrical device. Further, these alarms and indications are activated in response to a fault, and as a result, fail to monitor and alert consumers or utility companies as to an initial degradation of a system. This delay in notification of a degrading or damaged system leads to inefficient operation and delaying preventative maintenance and corrective action until a fault occurs.

In contrast to conventional systems, embodiments of the current invention provide for a utility meter which uses a DHMS to monitor a health status of at least one electrical device communicatively connected to the utility meter. Using the DHMS, the utility meter analyzes operational data obtained from the at least one electrical device and compares it with predefined operational criteria for the at least one electrical device to determine whether the electrical device is operating outside of a designed or optimal range. After processing the operational data, the utility meter may create or update an operational health profile for the at least one electrical device. The health profile including an operational history of the performance and/or maintenance of the at least one electrical device which may include trends in performance, past errors or faults, operating conditions or other diagnostic and analytical factors as are known in the art. The utility meter may further securely communicate any alerts, device identification tags (e.g., serial numbers, global positioning coordinates, device name or other identification data known in the art), operational data and/or operational health profiles to the utility and or consumer. The transmission of operational data or health profiles to the utility or consumer may be done periodically or in response to a command. The operational data and operational health profiles gathered and generated by the utility meter and DHMS may provide for more effective and timely preventative maintenance, more efficient device operation and an overall secure system.

As will be appreciated by one skilled in the art, the monitoring system described herein may be embodied as a system(s), method(s) or computer program product(s), e.g., as part of a monitoring system. Accordingly, embodiments of the present invention may take the form of an entirely hardware embodiment, an entirely software embodiment (including firmware, resident software, micro-code, etc.) or an embodiment combining software and hardware aspects that may all generally be referred to herein as a "circuit," "module," "network" or "system." Furthermore, the present invention may take the form of a computer program product embodied in any tangible medium of expression having computer-usable program code embodied in the medium.

Any combination of one or more computer usable or computer readable medium(s) may be utilized. The computer-useable or computer-readable medium may be, for example but not limited to, an electronic, magnetic, optical, electromagnetic, infrared, or semiconductor system, apparatus, or device. More specific examples (a non-exhaustive list) of the computer-readable medium would include the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a transmission media such as those supporting the Internet or an intranet, or a magnetic storage device. Note that the computer-usable or computer-readable medium could even be paper or another suitable medium upon which the program is printed, as the program can be electronically captured, via, for instance, optical scanning of the paper or other medium, then compiled, interpreted, or otherwise processed in a suitable manner, if necessary, and then stored in a computer memory. In the context of this document, a computer-usable or computer-readable medium may be any medium that can contain, store, communicate, or transport the program for use by or in connection with the instruction execution system, apparatus, or device. The computer-usable medium may include a propagated data signal with the computer-usable program code embodied therewith, either in baseband or as part of a carrier wave. The computer usable program code may be transmitted using any appropriate medium, including but not limited to wireless, wire line, optical fiber cable, RF, etc.

Computer program code for carrying out operations of the present invention may be written in any combination of one or more programming languages, including an object oriented programming language such as Java, Smalltalk, C++ or the like and conventional procedural programming languages, such as the "C" programming language or similar programming languages. The program code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

These computer program instructions may also be stored in a computer-readable medium that can direct a computer or other programmable data processing apparatus to function in a particular manner, such that the instructions stored in the computer-readable medium produce an article of manufacture including instruction means which implement the function/act specified in the block diagram block or blocks.

The computer program instructions may also be loaded onto a computer or other programmable data processing apparatus to cause a series of operational steps to be performed on the computer or other programmable apparatus to produce a computer implemented process such that the instructions which execute on the computer or other programmable apparatus provide processes for implementing the functions/acts specified in the flowchart and/or block diagram block or blocks.

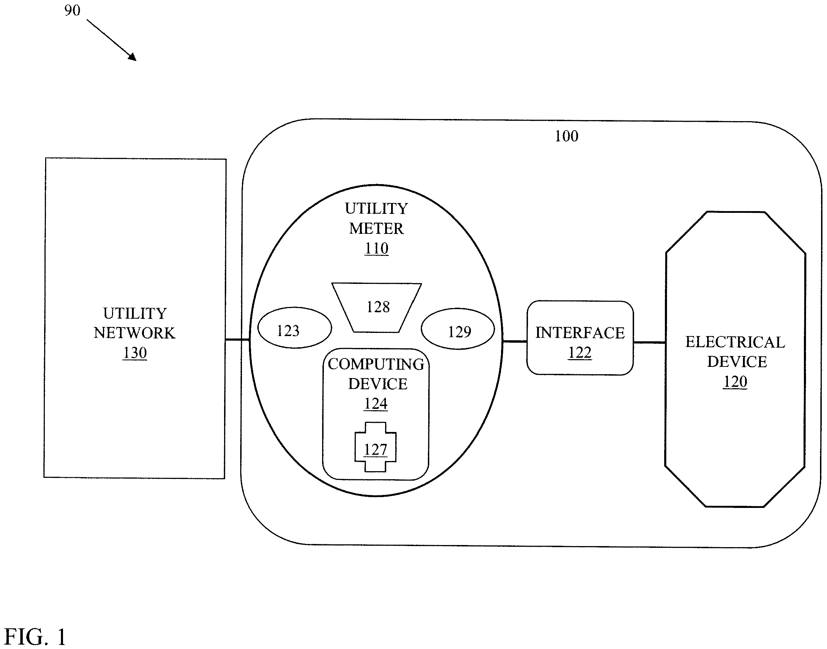

Turning to the Figures, embodiments of a monitoring system are shown, where the monitoring system may provide a utility company and or consumer with operational data for an electrical device, a health status of the electrical device and/or an operational health profile for the electrical device, thereby enabling the utility company and consumer to respond to electrical device failures and to improve electrical device efficiency. Each of the components in the Figures may be connected via conventional means, e.g., via wireless mesh, WiFi, power line communication, cellular, radio frequency, radio interface, Home Area Network (HAN), Local Area Network (LAN), Neighborhood Area Network (NAN), Advanced Metering Infrastructure (AMI), General Packet Radio Service (GPRS), Global System for Mobile communications (GSM), cellular interface, Worldwide Interoperability for Microwave Access (WiMAX), or other known means as is indicated in the Figs. 1-4. Specifically, referring to Fig. 1, a schematic illustration of an embodiment of an environment 90 including a monitoring system 100 is shown. Monitoring system 100 may include a utility meter 110 communicatively connected to an electrical device 120 via an interface 122. Utility meter 110 may comprise an electrical meter, a water meter, a gas meter, a smart meter or any other form of utility meter as is known in the art. In this embodiment, a computing device 124 on utility meter 110 receives communications including operational data (e.g. electrical parameters or a combination of electrical parameters such as, a voltage magnitude, a current magnitude, a power factor, a fault message, a error message, an amount of power consumption etc.) from electrical device 120 via interface 122. Computing device 124 on utility meter 110 processes the operational data, checking for fault messages and using a Device Health Monitoring System (DHMS) 127 to compare the operational data with predefined operational criteria for electrical device 120, thereby determining a health status for electrical device 120. Computing device 124 may then provide a health status indicator to a utility network 130 via utility meter 110, thereby providing any of the health status of electrical device 120, an operational status of electrical device 120 or a notification of an unsafe operating situation and/or condition at electrical device 120 to utility network 130. In one embodiment, if a variance between the operational data and predefined operational criteria is determined to be greater than a predetermined amount, then computing device 124 may, via utility meter 110 notify any or all of emergency services, a maintenance person, the utility or the consumer. The predetermined amount, which is the tolerable amount of variance between the operational data and the predefined operational criteria, may be determined by any of a utility, an electrical device designer or a consumer.

In one embodiment, computing device 124 may include a utility meter 110 processor. Interface 122 may comprise any interface known in the art, including but not limited to, a low-power digital radio, power line communication, a wireless local area network, wireless mesh, WiFi, radio frequency, radio interface, Home Area Network (HAN), Local Area Network (LAN), Neighborhood Area Network (NAN), Advanced Metering Infrastructure (AMI), General Packet Radio Service (GPRS), Global System for Mobile communications (GSM), cellular interface, Worldwide Interoperability for Microwave Access (WiMAX), or other known means. In one embodiment, interface 122 may be integrated into electrical device 120 to transmit operational data to utility meter 110. In another embodiment, computing device 124 may provide an error status indicator to utility meter 110 in response to receiving an error message or fault message as part of the operational data. In another embodiment, utility meter 110 may provide a safety shut-down command to electrical device 120 in response to a health status determination by DHMS 127, the safety shut-down command turning off power and/or removing power supply from electrical device 120. In another embodiment, DHMS 127 may diagnosis an error or fault message received by computing device 124 from electrical device 120 by comparing a most recently received set of operational data for electrical device 120 with either or both of stored operational data for electrical device 120 and the predefined operational criteria for electrical device 120.

In any event, computing device 124 can comprise any general purpose computing article of manufacture capable of executing computer program code installed by a user (e.g., a personal computer, server, handheld device, etc.). However, it is understood that computing device 124, interface 122, DHMS 127 and electrical device 120 are only representative of various possible equivalent computing devices that may perform the various process steps of the disclosure. To this extent, in other embodiments, computing device 124 can comprise any specific purpose computing article of manufacture comprising hardware and/or computer program code for performing specific functions, any computing article of manufacture that comprises a combination of specific purpose and general purpose hardware/software, or the like. In each case, the program code and hardware can be created using standard programming and engineering techniques, respectively.

Similarly, computing device 124 is only illustrative of various types of computer infrastructures for implementing the disclosure. For example, in one embodiment, computing device 124 comprises two or more computing devices (e.g., a server cluster) that communicate over any type of wired and/or wireless communications link, such as a network, a shared memory, or the like, to perform the various process steps of the disclosure. When the communications link comprises a network, the network can comprise any combination of one or more types of networks (e.g., the Internet, a wide area network, a local area network, a virtual private network, etc.). Network adapters may also be coupled to the system to enable the data processing system to become coupled to other data processing systems or remote printers or storage devices through intervening private or public networks. Modems, cable modem and Ethernet cards are just a few of the currently available types of network adapters. Regardless, communications between the computing devices may utilize any combination of various types of transmission techniques.

Returning to Fig. 1, in an embodiment of the present invention, computing device 124 may regularly update stored operational data from electrical device 120. In another embodiment, computing device 124 may provide periodic operational data reports or operational data profiles to utility network 130. In one embodiment, computing device 124 may process operational data about electrical device 120 and in response to receiving or processing an error message or fault message, computing device 124 may provide an error or fault indicator to utility network 130. In one embodiment, utility meter 110 may transmit operational data to utility network 130 in response to a command. In another embodiment, utility network 130 may include an Advanced Metering Infrastructure (AMI). In another embodiment, computing device 124 may obtain operational data for utility meter 110 and then process the operational data obtained from utility meter 110 with DHMS 127 to determine a health status of utility meter 110. In another embodiment, computing device 124 may obtain operational data for utility meter 110 and then process the operational data obtained from utility meter 110 with DHMS 127 to determine an operational status of utility meter 110. In one embodiment, computing device 124 may include an operational status in the health status indicator provided to utility meter 110. In one embodiment, operational data for utility meter 110 may be transmitted to utility network 130 via utility meter 110. In another embodiment, computing device 124 may display the health status of electrical device 120 on a display 128 disposed upon utility meter 110. In another embodiment, computing device 124 may activate an audible alarm 129 disposed upon utility meter 110 in response to DHMS 127 determining that electrical device 120 is operating with an unsafe condition. Audible alarm 129 being designed to produce an alarm sound to alert a consumer as to a particular health status of electrical device 120. In another embodiment, computing device 124 may, via utility meter 110, provide a health status indicator to at least one of a meter display, utility network 130, an emergency network, a maintenance network, an In-Home Display (IHD), a mobile device, an e-mail account and an audible alarm. In another embodiment, utility meter 110 may include computing device 124 and a meter base 123 configured to be connected to a power source and communicatively connected to electrical device 120. Meter base 123 being configured to monitor utility service consumption at utility meter 110.

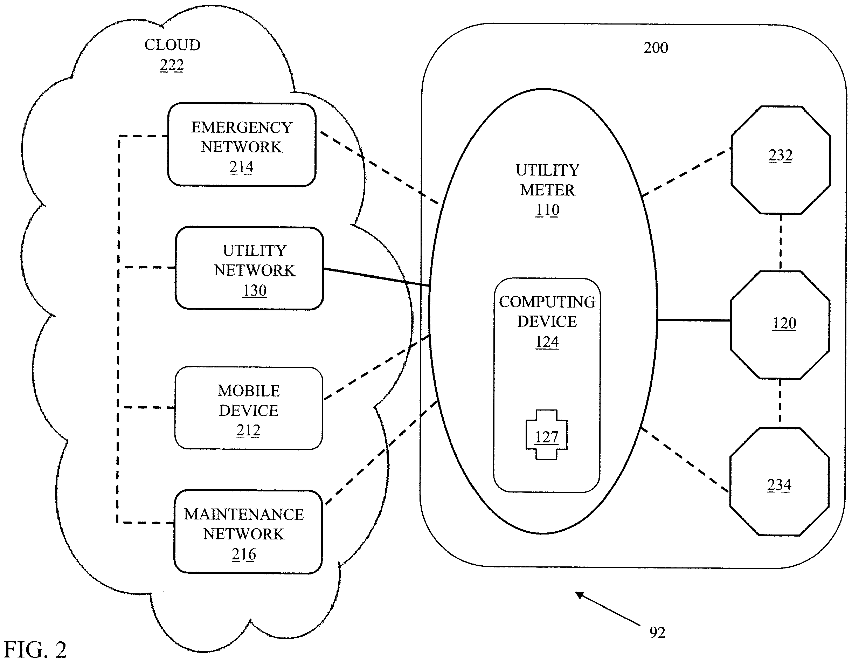

Turning to Fig. 2, a schematic illustration of an embodiment of an environment 92 including a monitoring system 200 including a plurality of electrical devices 232, 234 and 120 is shown. It is understood that elements similarly numbered between Fig. 1 and Fig. 2 may be substantially similar as described with reference to Fig. 1. Redundant explanation of these elements has been omitted for clarity. Returning to Fig. 2, in one embodiment, monitoring system 200 may include a plurality of electrical devices 232, 234 and 120 which may be communicatively connected to utility meter 110. The plurality of electrical devices 232, 234 and 120 may transmit operational data to utility meter 110 independently or collectively. In this embodiment, the plurality of electrical devices 232, 234 and 120 transmit communications including operational data to computing device 124 on utility meter 110 which securely processes the operational data via DHMS 127. In one embodiment, computing device 124 may transmit any of the operational data, the processed operational data, a health status, a health status indicator and/or an operational data profile to cloud 222. In one embodiment, utility meter 110 may transmit operational data for electrical devices 232, 120, and 234 cumulatively to cloud 222, thereby providing a localized report of all electronic devices serviced by utility meter 110. In another embodiment, utility meter 110 may transmit the operational data about one of electrical device 232, 120, or 234 independently to cloud 222, thereby providing a localized report specific to one of electrical device 232, 120, or 234. In one embodiment, cloud 222 may include utility network 130, a consumer-related device 212, an emergency network 214 for alerting emergency services as to a dangerous fault, and a maintenance network 216 for communicating operational data or a maintenance need to a maintenance service. In one embodiment, utility network 130 may obtain either or both of operational data or operational health status indicators from utility meter 110 and then rout either or both of operational data or operational health status indicators to any of emergency network 214, consumer-related device 212, and maintenance network 216. In another embodiment, utility meter 110 may transmit either or both of operational data or operational health status indicators directly to any of utility network 130, emergency network 214, consumer-related/mobile device 212, and maintenance network 216. Consumer-related/mobile device 212 may include any communications device known in the art, including but not limited to: a cell phone, an email account, a pager, a computer, etc.

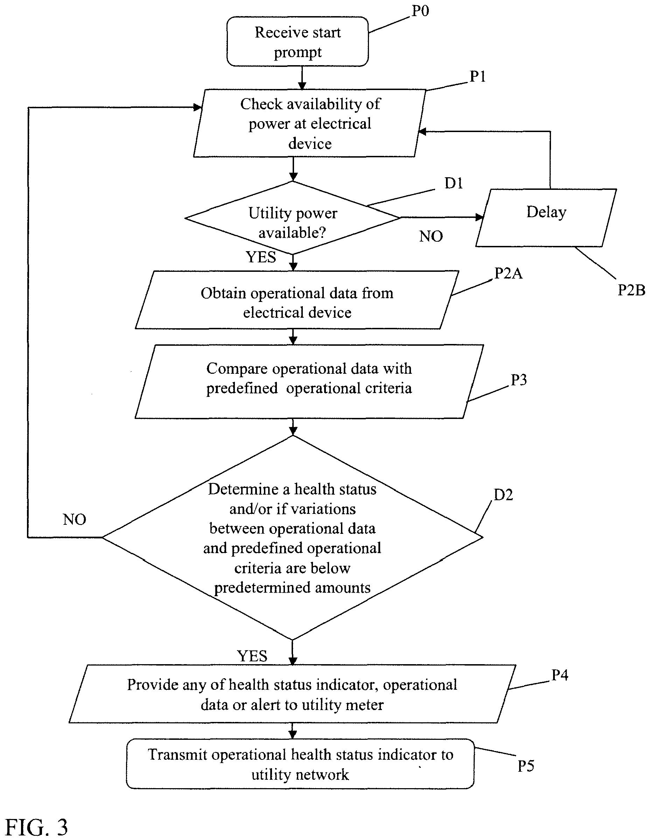

Turning to Fig. 3, an illustrative method flow diagram is shown according to embodiments of the invention: In pre-process P0, computing device 124 obtains a scheduled or user-prompted start indicator to begin a health prediction analysis of an electrical device 120. That is, either a scheduled test or a user-commanded test may be performed by computing device 124 on electrical device 120 in response to a prompt to determine a health status of electrical device 120. Following pre-process P0, in process P1, computing device 124 checks a power availability at electrical device 120. This may be done by conventional means such as a sensor communicatively connected to electrical device 120 or communication with electrical device 120. Following process P1, in decision D1, computing device 124 determines if power is available at electrical device 120. That is, computing device receives a response or non-response from the sensor or electrical device 120 indicating whether utility power is available at electrical device 120. That is, either a prompt is returned to computing device 124 from the sensor or electrical device 120 indicating whether power is available at electrical device 120 or no prompt is received within a specified time period and this non-response indicates that power is not available at electrical device 120. After decision D1, if power is determined to be not available at electrical device 120, then process P2B, computing device 124 waits a predetermined period of time and again performs process P1 and checks the availability of power at electrical device 120. However, if after performing decision D1, computing device 124 determines that power is available at electrical device 120, then in process P2A, computing device 124 may obtain operational data for electrical device 120 including but not limited to a device identification, error reports, caution reports, voltage, voltage magnitude, fault messages, power consumption, current magnitude, power factor, power, any other electrical parameters, or any combinations of these parameters etc. That is, computing device 124 may obtain operational data directly from electrical device 120. In another embodiment, computing device 124 may obtain operational data from sensors disposed within and/or upon electrical device 120.

Following process P2A, in process P3, computing device 124 uses Device Health Monitoring System (DHMS) 127 to compare obtained operational data from electrical device 120 with predefined operational criteria for electrical device 120. In one embodiment, the predefined operational criteria may be stored in computing device 124. In another embodiment, the predefined operational criteria may be stored in electrical device 120. In another embodiment, the predefined operational criteria may be accessed on utility network 130 via utility meter 110. In any event, following process P3, in decision D2, DHMS 127 may determine and/or calculate a degree of variation between the actual usage values and the predefined operational criteria for electrical device 120. In one embodiment, the degree of variation may be determined by a percent offset. In another embodiment, the variation may be determined by an absolute difference. In any event, computing device 124 determines if the variances determined in decision D2 are greater than a predetermined tolerable amount of variance. That is, computing device 124 compares the determined variances to variances that have been deemed optimal or tolerable by any of a designer, the utility or the consumer. If the variances are not determined to be larger than the predetermined variances (no to decision D2), then computing device 124 may revert back to process P1. However, if the variances are determined to be larger than the predetermined variances, then, following decision D2, in process P4, computing device 124 provides an alert notification and/or a health status indicator to utility meter 110. That is, computing device 124 may provide to utility meter 110 the health status indicator for transmission to cloud 222 to alert any of the utility, the consumer, emergency services or maintenance services. The health status indicator may include an identification number for electrical device 120, information about degradation of electrical device 120, a health status or health status profile of electrical device 120. Following process P4, in process P5, utility meter 110 transmits the operational health status indicator to utility network 130. In one embodiment, utility meter 110 may also transmit the operational data for electrical device 120 to cloud 222. In another embodiment, utility meter 110 may transmit the operational data for electrical device 120 to cloud 222 at any time.

The data flow diagram and block diagrams in the Figures illustrate the architecture, functionality, and operation of possible implementations of systems, methods and computer program products according to various embodiments of the present invention. In this regard, each block in the flowchart or block diagrams may represent a module, segment, or portion of code, which comprises one or more executable instructions for implementing the specified logical function(s). It should also be noted that, in some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts, or combinations of special purpose hardware and computer instructions.

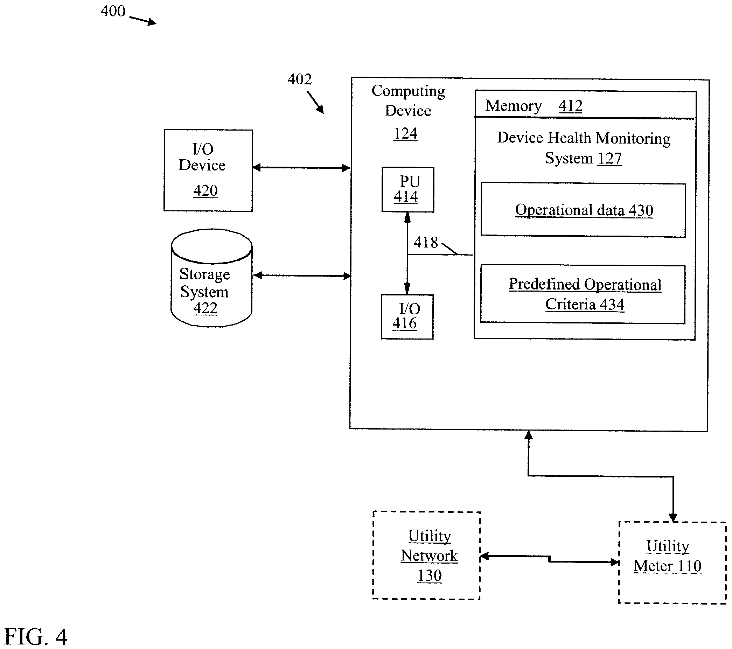

Turning to FIG. 4, an illustrative environment 400 including a device monitoring system 127 is shown according to embodiments of the invention. Environment 400 includes a computer infrastructure 402 that can perform the various processes described herein. In particular, computer infrastructure 402 is shown including computing device 124 which includes device health monitoring system 127, which enables computing device 124 to monitor electrical device 120 by performing the process steps of the disclosure.

As previously mentioned and discussed further below, Device Health Monitoring System (DHMS) 127 has the technical effect of enabling computing device 124 to perform, among other things, the electrical device monitoring functions described herein. It is understood that some of the various components shown in Fig. 4 can be implemented independently, combined, and/or stored in memory for one or more separate computing devices that are included in computing device 124. Further, it is understood that some of the components and/or functionality may not be implemented, or additional schemas and/or functionality may be included as part of monitoring system 100.

Computing device 124 is shown including a memory 412, a processor (PU) 414, an input/output (I/O) interface 416, and a bus 418. Further, computing device 124 is shown in communication with an external I/O device/resource 420 and a storage system 422. As is known in the art, in general, processor 414 executes computer program code, such as device monitoring system 127, that is stored in memory 412 and/or storage system 422. While executing computer program code, processor 414 can read and/or write data, such as operational data 430 and/or network predefined operational criteria data 434, to/from memory 412, storage system 422, and/or I/O interface 416. Bus 418 provides a communications link between each of the components in computing device 124. I/O device 420 can comprise any device that enables a user to interact with computing device 124 or any device that enables computing device 124 to communicate with one or more other computing devices. Input/output devices (including but not limited to keyboards, displays, pointing devices, etc.) can be coupled to the system either directly or through intervening I/O controllers.

In some embodiments, as shown in FIG. 4, environment 400 may optionally include utility meter 110 and utility network 130 communicatively connected to device health monitoring system 127 through computing device 124 (e.g., via wireless or hardwired means). In some embodiments, computing device 124 and/or device health monitoring system 127 may be disposed upon or within utility meter 110.

As discussed herein, various systems and components are described as "obtaining" data (e.g., temperatures, grid frequency, etc.). It is understood that the corresponding data can be obtained using any solution. For example, the corresponding system/component can generate and/or be used to generate the data, retrieve the data from one or more data stores or sensors (e.g., a database), receive the data from another system/component, and/or the like. When the data is not generated by the particular system/component, it is understood that another system/component can be implemented apart from the system/component shown, which generates the data and provides it to the system/component and/or stores the data for access by the system/component.

The foregoing drawings show some of the processing associated according to several embodiments of this disclosure. In this regard, each drawing or block within a flow diagram of the drawings represents a process associated with embodiments of the method described. It should also be noted that in some alternative implementations, the acts noted in the drawings or blocks may occur out of the order noted in the figure or, for example, may in fact be executed substantially concurrently or in the reverse order, depending upon the act involved. Also, one of ordinary skill in the art will recognize that additional blocks that describe the processing may be added.

The monitoring system of the present disclosure is not limited to any one particular meter, electrical meter, smart meter, network or other system, and may be used with other power and communication systems. Additionally, the monitoring system of the present invention may be used with other systems not described herein that may benefit from the accurate, secure, real-time data communications link, diagnosis and analysis provided by the monitoring system described herein.

It is understood that as described herein, electrical device 120 may include one or more conventional electrical devices including but not limited to: a vital signs monitor, an activity monitor, a computer, a refrigerator, an alarm system, a cooking range, a smart meter, an intelligent electrical device, a television, a power management unit, a programmable communicating thermostat, an air conditioning system, a heating system.

The terminology used herein is for the purpose of describing particular embodiments only and is not intended to be limiting of the disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims.

## Claims

1. A method of monitoring an electrical device (120, 232, 234),
the electrical device (120,232,234) communicatively connected to a utility meter (110), the method comprising:
obtaining operational data (430) about the electrical device (120, 232, 234);
(P2A)
comparing the operational data (430) about the electrical device (120, 232, 234) with predefined operational criteria (434) for the electrical device (120, 232, 234); (P3)
determining a health status for the electrical device (120, 232, 234) based upon the comparison of the operational data (430) about the electrical device (120, 232, 234) and the predefined operational criteria (434) for the electrical device (120, 232, 234); (D2) and
providing to the utility meter (110), a health status indicator, the health status indicator including an operational status of the electrical device (120, 232, 234). (P4)

2. The method of claim 1, wherein the operational data (430) is selected from electrical parameters including at least one of: an error message, a fault message, a voltage magnitude, a current magnitude, a power factor and an amount of power consumption.

3. The method of claim 1 or 2, wherein the health status indicator is transmitted via the utility meter (110) to at least one of: a meter display (128), a utility network (130), an In-Home Display (IHD), a mobile device (212), an e-mail account, an audible alarm (129), an emergency network (214) and a maintenance network (216). (P5)

4. The method of any of claims 1 to 3, further comprising storing the operational data (430, 434) over time and generating a health profile for the electrical device (120, 232, 234) based on the stored operational data (430, 434).

5. The method of any of claims 1 to 4, further comprising providing an error status indicator to the utility meter (110) in response to an error message being received as part of the operational data (430). (P5)

6. The method of any preceding claim, wherein the determining of the health status (D2) for the electrical device (120, 232, 234) includes:
calculating a degree of variation between the operational data (430) about the electrical device (120, 232, 234) and the predefined operational criteria (434) for the electrical device (120, 232, 234); (D2) and
providing an alert notification to the utility meter (110) if the degree of variation is greater than a predetermined amount. (P4)

7. The method of claim 6, further comprising providing a command to remove power supply to the electrical device (120, 232, 234) if the operational data (430) for the electrical device (120, 232, 234) varies from the predefined operational criteria (434) for the electrical device (120, 232, 234) by more than the predetermined amount.

8. The method of claim 8, wherein the predetermined amount is defined by any of: a utility, an electrical device designer or a consumer.

9. A computer program comprising computer program code means arranged to perform the steps of the method of any of claims 1 to 8, when run on a computer disposed upon a utility meter.

10. The computer program of claim 9, embodied on a computer readable medium (402,412,422).

11. A monitoring system (100,200) for an electrical device (120,232,234) comprising:
a utility meter (110) communicatively connected to the electrical device (120,232,234); and
at least one computing device (124) disposed within the utility meter, the at least one computing device adapted to monitor the electrical device by performing the steps of the method of any of claims 1 to 9.

12. The monitoring system of claim 11, wherein the device (124) includes a utility meter processor (110).

13. A utility meter (110) comprising:
a meter base (123) configured to be connected to a power source and communicatively connected to at least one electrical device (120, 232, 234); and
at least one computing device (124) communicatively connected to the meter base (123), the at least one computing device (124) adapted to determine a health status of the at least one electrical device (120, 232, 234) by all the steps of the method of any of claims 1 to 9.
